# FASCICULE DE BREVET EUROPEEN

(11) **EP 0 702 409 B1**
(45) Date de publication et mention de la délivrance du brevet: **05.08.1998**
(21) Numéro de dépôt: 95410107.7
(22) Date de dépôt: 13.09.1995
(51) Int. Cl.: H01L 25/04, H01L 31/0232

(54) **Empilement en série de thyristors photosensibles**
Stapel mit in Serie verbundenen fotoempfindlichen Thyristoren
Stack of series-connected photosensitive thyristors

(30) Priorité: 16.09.1994 FR 9411338
(43) Date de publication de la demande: 20.03.1996
(73) Titulaire: SGS-THOMSON MICROELECTRONICS S.A., 94250 Gentilly (FR)
(72) Inventeur: Pezzani, Robert, F-37210 Vouvray (DE)
(74) Mandataire: de Beaumont, Michel

(56) Documents cités:
- EP-A- 0 345 972
- PATENT ABSTRACTS OF JAPAN vol. 005 no. 055 (E-052) ,16 Avril 1981 & JP-A-56 007476 (MITSUBISHI ELECTRIC CORP) 26 Janvier 1981,
- PATENT ABSTRACTS OF JAPAN vol. 004 no. 175 (E-036) ,3 Décembre 1980 & JP-A-55 120165 (NEC CORP) 16 Septembre 1980,

## Description

La présente invention concerne le domaine des thyristors photosensibles. Elle s'applique plus particulièrement aux thyristors en technologie planar.

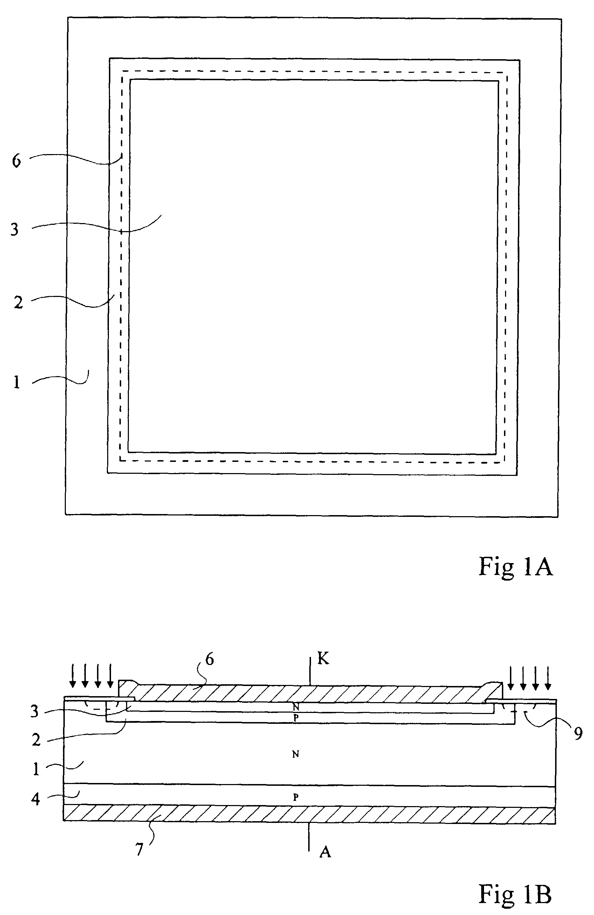

Les figures 1A et 1B représentent respectivement une vue de dessus et une vue en coupe schématique d'un thyristor photosensible de type planar. Celui-ci comprend comme tout thyristor classique un substrat 1 d'un premier type de conductivité faiblement dopé, par exemple de type N. Sur la face supérieure du substrat sont successivement formées une première région 2 de type P et, à l'intérieur de la région 2, une région 3 de type N. La face inférieure comporte une couche 4 de type P. La structure est de type planar car les régions P et N de la face supérieure sont formées par diffusion à l'intérieur d'un masque et que leurs jonctions ne débouchent pas à la périphérie du thyristor mais sur la face supérieure de celui-ci. De telles structures sont particulièrement simples à réaliser et présentent une bonne tenue en tension. La région supérieure 3 de type N est revêtue d'une métallisation 6 et constitue une électrode de cathode K. La face inférieure est revêtue d'une métallisation 7 et constitue une électrode d'anode A.

Contrairement à un thyristor classique, un thyristor photosensible ne comprend pas de métallisation de gâchette mais est déclenché par irradiation de la jonction bloquante en direct, c'est-à-dire la jonction entre la région 2 et le substrat 1. Cette jonction sera appelée ci-après "jonction photosensible". L'irradiation est illustrée en figure 1B par des flèches et agit essentiellement dans la région 9 illustrée en pointillés au voisinage de l'affleurement de la jonction photosensible. Classiquement, la source de lumière est une diode électroluminescente de longueur d'onde adaptée et convenablement positionnée par rapport à la région sensible du thyristor. Cette région est comme on l'a indiqué la région voisine de l'affleurement de la jonction entre la région 2 et le substrat 1 dans laquelle se développe le champ électrique en régime de blocage direct. Les photons captés génèrent des paires électrons-trous qui, par l'énergie acquise dans le champ électrique, vont se multiplier et entraîner l'amorçage du thyristor. Il est clair que ces photons accèdent seulement à la partie superficielle du composant. En effet, ils sont absorbés dès qu'ils atteignent la surface du composant et voient leur densité (et donc leur efficacité) décroître au fur et à mesure que l'on s'éloigne de la surface. Il est donc nécessaire d'éclairer la face supérieure du composant et principalement la zone d'affleurement de la jonction photosensible. Un éclairement latéral ne pourrait atteindre la région de jonction et provoquer le déclenchement du thyristor.

Un thyristor classique est décrit dans JP-A-55 120 165.

Pour certaines applications, par exemple si l'on veut provoquer un déclenchement alors que le thyristor supporte des tensions directes de l'ordre de plusieurs kilovolts, il est souhaitable d'utiliser plusieurs thyristors photosensibles en série. On est alors amené à disposer les thyristors côte à côte pour pouvoir éclairer leurs faces avant. Il en résulte un montage d'encombrement important.

La présente invention vise à réaliser un empilement en série de thyristors photosensibles de type planar à faible encombrement selon la revendication 1.

Pour atteindre cet objet, la présente invention prévoit un empilement en série de composants photosensibles de type planar ayant une première face principale sur laquelle affleure une jonction photosensible et une deuxième face principale, dans lequel les composants sont empilés de sorte que la deuxième face principale d'un composant soit au contact avec la première face principale du composant adjacent, et la deuxième face principale de chaque composant comporte une encoche sur sa périphérie sur une étendue latérale correspondant au moins à la distance entre la jonction photosensible et la périphérie.

Selon un mode de réalisation de la présente invention, l'encoche est recouverte d'une métallisation recouvrant aussi la deuxième face principale de chaque composant.

Selon un mode de réalisation de la présente invention, l'encoche est de forme concave.

Selon un mode de réalisation de la présente invention, l'encoche résulte d'une gravure chimique d'une plaque de silicium à partir de laquelle ont été formés les composants.

Selon un mode de réalisation de la présente invention, au moins une source lumineuse est disposée à la périphérie de l'empilement.

Selon un mode de réalisation de la présente invention, les composants sont des thyristors.

Ces objets, caractéristiques et avantages ainsi que d'autres de la présente invention seront exposés plus en détail dans la description suivante de modes de réalisation particuliers faite, à titre non-limitatif, en relation avec les figures jointes parmi lesquelles :
les figures 1A et 1B, décrites précédemment, représentent une vue de dessus et une vue en coupe schématique d'un thyristor planar photosensible ;
la figure 2 représente une vue en coupe d'un assemblage de thyristors photosensibles selon la présente invention ;
la figure 3 représente une vue de côté, avec une indication de dimensions, d'un exemple pratique de thyristor photosensible selon la présente invention.

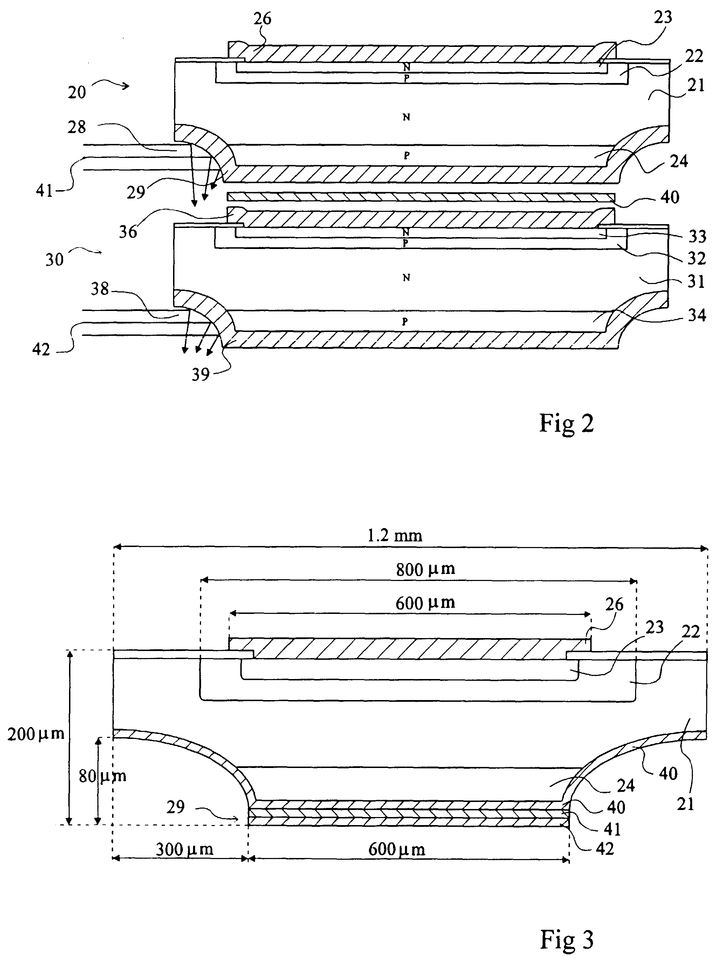

La figure 2 représente deux thyristors photosensibles de type planar 20 et 30 respectivement similaires à celui des figures 1A et 1B. Ces deux thyristors photosensibles 20 et 30 comprennent respectivement un substrat 21, 31, une région de type P 22, 32, une région de type N 23, 33, et une couche inférieure de type P 24, 34, similaires aux éléments 1, 2, 3, 4 des figures 1A et 1B. Ils comprennent également des métallisations supérieures de cathodes respectives 26, 36 similaires à la métallisation 6.

Les thyristors 20 et 30 diffèrent du thyristor de la figure 1B par leur face inférieure. La périphérie de cette face inférieure est largement rainurée pour former une encoche latérale 28, 38. Cette encoche a une étendue latérale supérieure à la distance, du côté de la face supérieure, entre la périphérie de chaque thyristor et la zone d'affleurement de jonction des régions 22, 32. L'encoche latérale 28, 38 est métallisée en même temps que la face inférieure par des métallisations respectives 29, 39.

Les deux thyristors 20, 30, ainsi que d'autres non représentés, sont empilés et soudés ensemble, éventuellement par interposition d'une préforme de soudure 40. Ainsi, un faisceau lumineux 41, 42 arrivant sur la périphérie des thyristors une fois ceux-ci assemblés sera réfléchi par le miroir constitué par la métallisation 29 de l'encoche 28 vers l'affleurement de jonction du thyristor immédiatement inférieur. Les métallisations habituellement utilisées pour former des métallisations d'anode et/ou de cathode constituent généralement des réflecteurs satisfaisants. Il s'agira par exemple de métallisations formées à partir d'aluminium, d'or, de titane, de nickel, isolément ou en superposition ou en alliage, éventuellement avec du silicium, etc.

L'encoche 28, 38 a de préférence une forme concave. Ainsi, non seulement les rayons lumineux sont réfléchis vers la face inférieure mais en plus ils se concentrent vers la zone photosensible à condition que le rayon de courbure des encoches soit convenablement choisi. Dans le domaine des semiconducteurs dans lequel des composants individuels sont formés à partir d'une plaque de silicium de grande surface qui est ensuite sciée en composants individuels, des encoches concaves pourront être réalisées d'une façon classique par sillonnage : avant sciage dans les zones correspondant aux limites des thyristors, on forme par gravure chimique des sillons qui constitueront ensuite lesdites encoches.

On notera que, si les encoches sont relativement larges et profondes, la métallisation 29, 39 sera en contact non seulement avec les couches 24, 34 de type P mais aussi avec les substrats 21, 31, respectivement. En pratique, ceci ne présente pas d'inconvénient. D'une part, il faut rappeler que la qualité de la jonction entre le substrat N et la région P inférieure influe essentiellement sur la tenue en tension inverse d'un thyristor. Or, cette tenue en tension inverse n'est généralement pas un paramètre important dans les utilisations classiques des thyristors photosensibles. D'autre part, la mise en contact de la métallisation de face arrière avec le substrat ne constitue pas un court-circuit à faible impédance. En effet, la résistivité du substrat de type N est élevée (couramment de l'ordre de 25 ohm-cm ou 10¹⁴ atomes/cm³). A de telles concentrations, il n'y a pas de contact ohmique entre la métallisation et le substrat, c'est-à-dire que, sous une tension de 1 volt, la résistance de contact sera de plusieurs kilohms. Donc, en fait, la métallisation ne court-circuite pas la jonction arrière et ne dégrade pratiquement pas la sensibilité du thyristor.

A titre d'exemple numérique, la présente invention peut s'appliquer à un thyristor photosensible carré ayant les dimensions représentées en figure 3, susceptible de supporter une tension directe de l'ordre de 600 V et de laisser passer un courant moyen de l'ordre de l'ampère (des pointes de courant de l'ordre de 50 A).

Les caractéristiques des régions semiconductrices sont par exemple les suivantes :
substrat 21 : concentration en dopants = 1014 at./cm³, régions P 22 et 24 : xₛ = 16 µm, Cₛ = 10¹⁷ at./cm³,
région N 23 : xₛ = 8 µm, Cₛ = 2.1019 at./cm³.
où xₛ désigne la profondeur de pénétration des dopants et Cₛ la concentration des dopants en surface.

Un empilement de jusqu'à dix thyristors photosensibles du type de celui de la figure 3 pourra être réalisé pour atteindre une tenue en tension de l'ordre de 6000 V.

Classiquement l'empilement de thyristors sera déclenché par une photodiode unique bien que des montages plus complexes puissent être imaginés. En fait, il n'est pas nécessaire que tous les photothyristors se déclenchent optiquement puisque, dès qu'un certain nombre de thyristors photosensibles aura été déclenché, les autres s'amorceront par retournement.

Par ailleurs, on a décrit précédemment une métallisation unique 29 de face arrière. En pratique, on pourra procéder à une première métallisation 40, par exemple en aluminium, sur l'ensemble de la face arrière puis à une ou plusieurs métallisations sur la partie plane de la face arrière, par exemple une deuxième métallisation de nickel 41 et une troisième métallisation d'or 42. Ainsi, une soudure tendre, par exemple à l'étain-plomb mouillera l'or et pas l'aluminium, c'est-à-dire qu'elle n'aura pas tendance à remplir l'encoche. Ceci peut être réalisé en effectuant d'abord un dépôt d'aluminium 40, en recouvrant de résine les sillons, en déposant des métallisations supplémentaires, puis en dissolvant la résine, ce qui élimine du même fait les métallisations recouvrant la résine.

Tous les types de conductivité pourront être inversés et l'invention s'applique de façon similaire à des diodes, triacs et autres composants photosensibles de type planar.

## Revendications

1. Empilement en série de composants photosensibles de type planar ayant une première face principale supérieure sur laquelle affleure une jonction photosensible et une deuxième face principale inférieure opposé à la face principale supérieure, caractérisé en ce que :
lesdits composants (20, 30) sont empilés de sorte que la deuxième face principale d'un composant soit au contact avec la première face principale du composant adjacent, et
la deuxième face principale de chaque composant comporte une encoche (28, 38) sur sa périphérie sur une étendue latérale correspondant au moins à la distance entre la zone d'affleurement de ladite jonction photosensible et le côté de la première face principale.

2. Empilement en série de composants photosensibles selon la revendication 1, caractérisé en ce que l'encoche est recouverte d'une métallisation recouvrant aussi la deuxième face principale de chaque composant.

3. Empilement en série de composants photosensibles selon la revendication 1, caractérisé en ce que l'encoche est de forme concave.

4. Empilement en série de composants photosensibles selon la revendication 1, caractérisé en ce que l'encoche résulte d'une gravure chimique d'une plaque de silicium à partir de laquelle ont été formés les composants.

5. Empilement en série de composants photosensibles selon les revendications 2 et 4, caractérisé en ce que la partie plane de la deuxième face principale inférieure est revêtue de métallisations supplémentaires (41, 42).

6. Empilement en série de composants photosensibles selon la revendication 1, caractérisé en ce qu'il est associé à au moins une source lumineuse (70) disposée à la périphérie de l'empilement.

7. Empilement en série de composants photosensibles selon la revendication 1, caractérisé en ce que les composants sont des thyristors.

## Patentansprüche

1. Stapel aus in Reihe geschalteten lichtempfindlichen Planar-Bauteilen, die jeweils eine erste obere Hauptoberfläche, an welcher ein lichtempfindlicher pn-Übergang austritt, sowie eine dieser oberen Hauptoberfläche gegenüberliegende zweite untere Hauptoberfläche aufweisen,
**dadurch gekennzeichnet,** daß
die genannten Bauteile (20, 30) so gestapelt sind, daß die zweite Hauptoberfläche eines Bauteils in Kontakt mit der ersten Hauptoberfläche des benachbarten Bauteils steht, und
daß die zweite Hauptoberfläche jedes Bauteils jeweils an ihrem Umfang eine Ausnehmung bzw. Nut (28,38) aufweist, deren seitliche Erstreckung wenigstens dem Abstand zwischen der Austrittszone des genannten lichtempfindlichen pn-Übergangs und der Seite bzw. dem Rand der ersten Hauptoberfläche entspricht.

2. Reihenschaltungs-Stapel aus lichtempfindlichen Bauteilen, nach Anspruch 1, dadurch gekennzeichnet, daß die Ausnehmung bzw. Nut mit einer Metallisierung überzogen ist, welche auch jeweils die zweite Hauptoberfläche jedes Bauteils bedeckt.

3. Reihenschaltungs-Stapel aus lichtempfindlichen Bauteilen, nach Anspruch 1, dadurch gekennzeichnet, daß die Ausnehmung bzw. Nut konkave Form besitzt.

4. Reihenschaltungs-Stapel aus lichtempfindlichen Bauteilen, nach Anspruch 1, dadurch gekennzeichnet, daß die Ausnehmung bzw. Nut durch eine chemische Ätzung eines Siliziumplättchens erhalten wird, aus welchem die Bauteile hergestellt wurden.

5. Reihenschaltungs-Stapel aus lichtempfindlichen Bauteilen, nach den Ansprüchen 2 bis 4, dadurch gekennzeichnet, daß der plan-ebene Teil der unteren zweiten Hauptoberfläche mit zusätzlichen Metallisierungen überzogen ist.

6. Reihenschaltungs-Stapel aus lichtempfindlichen Bauteilen, nach Anspruch 1, dadurch gekennzeichnet, daß er wenigstens einer am Umfang des Stapels angeordneten Lichtquelle (70) zugeordnet ist.

7. Reihenschaltungs-Stapel aus lichtempfindlichen Bauteilen, nach Anspruch 1, dadurch gekennnzeichnet, daß die Bauteile Thyristoren sind.

## Claims

1. A serial stack of photosensitive components of the planar-type having a first upper main surface that is intersected by a first photosensitive junction appears at the surface and a second lower main surface opposed to the upper main surface, characterized in that:
said components (20, 30) are piled so that the second main surface of a component contacts the first main surface of the adjacent component, and
the second main surface of each component has a notch (28, 38) at its periphery along a lateral length corresponding at least to the distance between the intersection of said photosensitive junction and the periphery of the first main surface.

2. The serial stack of photosensitive components of claim 1, characterized in that the notch is coated with a metallization which also coats the second main surface of each component.

3. The serial stack of photosensitive components of claim 1, characterized in that the notch is concave.

4. The serial stack of photosensitive components of claim 1, characterized in that the notch is formed by chemically etching a silicon wafer from which the components are formed.

5. The serial stack of photosensitive components of claims 2 and 4, characterized in that the planar portion of the second lower main surface is coated with additional metallizations (41, 42).

6. The serial stack of photosensitive components of claim 1, characterized in that it is associated with at least one light source (70) disposed at the periphery.

7. The serial stack of photosensitive components of claim 1, wherein said components are thyristors.
